# FASCICULE DE BREVET EUROPEEN

(11) **EP 3 291 655 B1**
(45) Date de publication et mention de la délivrance du brevet: **22.05.2019**
(21) Numéro de dépôt: 17188476.0
(22) Date de dépôt: 30.08.2017
(51) Int. Cl.: H05K 1/02, H05K 3/36

(54) **CIRCUIT IMPRIMÉ FLEXIBLE ET PROCÉDÉ DE CONNEXION SÉCURISÉE CORRESPONDANT**
FLEXIBLE SCHALTUNG, UND ENTSPRECHENDES GESICHERTES ANSCHLUSSVERFAHREN
FLEXIBLE PRINTED CIRCUIT AND CORRESPONDING SECURE CONNECTION METHOD

(30) Priorité: 31.08.2016 FR 1658097
(43) Date de publication de la demande: 07.03.2018
(73) Titulaire: INGENICO GROUP, 75015 Paris (FR)
(72) Inventeur: PHILIBERT, Eric, 38160 SAINT- MARCELLIN (FR); ALLIROT, Richard, 38700 CORRENC (FR)
(74) Mandataire: Vidon Brevets & Stratégie

(56) Documents cités:
- EP-A2- 0 540 319
- US-A- 5 900 587
- US-A1- 2008 023 214

## Description

### 1 DOMAINE TECHNIQUE

Le domaine de l'invention est celui des circuits imprimés flexibles, (ou FPC pour « Flexible Printed Circuit board » en anglais), aussi appelés « flex PCB » ou « circuits flex ».

Plus précisément, l'invention concerne un circuit imprimé flexible ainsi qu'un procédé de connexion sécurisée associé permettant de prévenir l'accès aux signaux transitant via des points de brasage (ou points de soudure) lorsque ce dernier est brasé (ou soudé) à un autre circuit électronique.

Dans la suite de la description, on utilise de manière indifférenciée les termes « soudure » (« soudé ») et « brasage » (« brasé »).

L'utilisation des circuits imprimés flexibles est très répandue dans l'industrie, par exemple pour relier deux circuits imprimés rigides entre eux dans des configurations spatiales complexes. Par ailleurs, de nombreux domaines exigent des niveaux de sécurité élevés en termes de confidentialité des signaux électriques transitant dans les équipements. L'invention a ainsi de nombreuses applications, notamment, mais non exclusivement, dans les domaines des terminaux de paiement électronique, les lecteurs de cartes de paiement, etc.

### 2 ARRIERE-PLAN TECHNOLOGIQUE

Lors du développement de fonctionnalités électroniques complexes, il est souvent nécessaire de connecter électriquement différents circuits imprimés entre eux.

Pour ce faire, l'utilisation des circuits imprimés flexibles (FPC) peut s'avérer très intéressante. En effet, de telles liaisons flexibles permettent par exemple de relier entre eux des circuits rigides dans des configurations spatiales complexes, permettant par là-même de gagner de la place.

En pratique, un tel FPC comprend une couche de pistes conductrices comprise entre deux couches de matière plastique souple, par exemple du polyimide, ainsi qu'éventuellement une deuxième couche de pistes conductrices disposée sur une des faces externes du FPC (destinée par exemple à implémenter un treillis de sécurité comme indiqué ci-dessous). Il s'ensuit qu'une technique de brasage particulièrement adaptée à ce type de circuit souple est la technique de brasage par thermode, ou « hot bar » en anglais.

En pratique, deux types de mises en oeuvre de cette technique de brasage peuvent être envisagés. Dans le premier type (dit « à simple face », ou « single-sided flex » en anglais), seule une des deux couches de matière plastique souple est ajourée de manière à permettre l'accès aux pistes que l'on veut braser. En pratique, lors du brasage, les pistes rendues accessibles sont appliquées sur les points de pâte à braser préalablement disposés sur les pistes du circuit imprimé auquel on veut les braser. La thermode est alors appliquée sur la couche de matière plastique souple disposée sur la face du FPC opposée à la face ajourée. Ainsi, les points de pâte à braser sont chauffés par diffusion de la chaleur d'une part à travers la couche de matière plastique souple non ajourée sur laquelle la thermode est appliquée, et d'autre part à travers les pistes à braser.

Il apparaît cependant que cette première mise en oeuvre est problématique à différents égards. Tout d'abord, l'échauffement de la couche de matière plastique souple en contact avec la thermode peut conduire à sa dégradation. Ceci est d'autant plus marqué que pour arriver à un échauffement suffisant de la pâte à braser, l'énergie à fournir à la couche de matière plastique souple est supérieure à ce qu'elle serait en cas de contact direct avec les pistes à braser. Cette problématique est exacerbée dans le cas où la couche de matière plastique souple en contact avec la thermode est recouverte d'une deuxième couche de pistes conductrices, par exemple en cuivre, le métal se trouvant être un bon conducteur thermique.

Par ailleurs, selon cette première technique, la pâte à braser en excès ne peut être évacuée en remontant de part et d'autre des différentes pistes à braser : elle est en effet plaquée dans le plan des pistes à braser et au niveau du circuit imprimé sur lequel on brase le FPC par la présence de la couche de matière plastique souple en contact avec la thermode. Ainsi, en cas d'excès de pâte à braser, un court-circuit peut apparaître entre deux pistes adjacentes. Un tel phénomène conduit alors à des contraintes supplémentaires pour la mise en production du système électronique complet et impacte ainsi son coût final.

Pour ces différentes raisons, il est souvent préférable de s'orienter vers un deuxième type de mise en oeuvre de brasage par thermode dans lequel les deux couches de matière plastique souple sont toutes deux ajourées, ainsi que la deuxième couche de pistes conductrices le cas échéant, au niveau de la portion des pistes que l'on veut braser (méthode de brasage par thermode du type « à fenêtre » (ou « open windowed flex » en anglais) ou du type « à pistes exposées » (ou « exposed lead flex » en anglais)). Ainsi, la thermode est directement appliquée sur les portions des pistes à braser qui sont dans ce cas entièrement mises à nu, améliorant par là-même le transfert thermique. La problématique de l'évacuation de l'excès de pâte à braser est également résolue (les orifices entre les pistes servent à évacuer un excès de pâte à braser).

Un inconvénient de ce deuxième type de mise en oeuvre est que les pistes du FPC qui ont été brasées sont maintenant accessibles. En effet, les deux couches de matière plastique souple, ainsi que la deuxième couche de pistes conductrices le cas échéant, ayant été ajourées pour permettre d'appliquer la thermode directement sur les pistes du FPC, les signaux électriques transitant entre le FPC et le circuit électronique auquel il vient d'être brasé sont accessibles et peuvent être espionnés. Cette situation est particulièrement problématique dans certains domaines d'application où un tel accès n'est pas autorisé, par exemple dans les dispositifs qui gèrent des données confidentielles comme les terminaux de paiement, les lecteurs de cartes de paiement, etc. En effet, des signaux sensibles transitent entre les circuits imprimés. Ces signaux sensibles sont par exemple représentatifs d'un compte bancaire, d'un code secret comme par exemple un code « pin » (pour « Personal Identification Number » en anglais). Il est donc nécessaire d'en prévenir l'accès.

Par ailleurs, les FPC connus utilisés dans de tels domaines d'application présentent classiquement des moyens de détection d'une tentative d'intrusion et d'accès aux signaux qui transitent par les pistes qu'ils comportent (e.g. des treillis de sécurité comprenant des pistes conductrices disposées sur une deuxième couche de cuivre du FPC telle que décrite ci-dessus). Il y a ainsi un intérêt à obtenir la même fonctionnalité vis-à-vis des signaux transitant par les points de brasage, i.e. de pouvoir détecter une tentative d'accès à ces signaux, et cela tout en préservant le coût de la solution finale.

Il existe ainsi un besoin pour un FPC permettant d'être brasé par une méthode de brasage par thermode du type « à fenêtre » ou du type « à pistes exposées » tout en empêchant l'accès aux signaux électriques transitant entre le FPC et le circuit électronique auquel il vient d'être brasé.

Il existe également un besoin pour qu'un tel FPC offre des moyens de détection d'une tentative d'accès aux signaux électriques ainsi protégés après brasage.

Il existe enfin un besoin pour qu'un tel FPC conduise à une solution globale au coût et à l'encombrement maitrisés.

US200802223214 divulgue une circuit imprimé flexible comprenant un élément à braser à un circuit imprimé rigide, mais il ne divulgue pas au moins une partie rabattable.

### 3 RESUME

Dans un mode de réalisation de l'invention, il est proposé un circuit imprimé flexible comprenant au moins un élément à braser possédant une face à braser, accessible depuis une première face du circuit imprimé flexible, et une face à chauffer, accessible depuis une deuxième face du circuit imprimé flexible.

Un tel circuit imprimé flexible comprend en outre une partie principale, comprenant ledit au moins un élément à braser, et au moins une partie rabattable, s'étendant à partir de ladite partie principale et configurée pour passer :
- d'un état non rabattu, dans lequel ladite au moins une partie rabattable ne recouvre pas la face à chauffer dudit au moins un élément à braser ;
- à un état rabattu, dans lequel ladite au moins une partie rabattable recouvre la face à chauffer dudit au moins un élément à braser.

Ainsi, l'invention propose une solution nouvelle et inventive pour permettre la sécurisation d'un FPC destiné à être brasé, par exemple à un autre circuit électronique, via une technique de brasage nécessitant l'accès aux éléments à braser depuis les deux faces du FCP (comme par exemple la technique de brasage par thermode, dite « hot bar », notamment dans ses mises en oeuvre dites « à fenêtre » et « à pistes exposées »).

Pour ce faire, le FPC selon l'invention présente une partie rabattable destinée à recouvrir la face à chauffer des éléments à braser du FPC. De la sorte, les points de brasure obtenus deviennent inaccessibles, interdisant ainsi l'espionnage des signaux qui y transitent.

Par ailleurs, la solution proposée n'implique qu'une portion de FPC supplémentaire (i.e. la partie rabattable) par rapport à un FPC de l'état de la technique. Le coût de la solution proposée reste ainsi minimal.

Enfin, le FCP ainsi obtenu après rabattement reste tout à fait plat, ce qui permet de minimiser l'encombrement du système électronique complet obtenu après assemblage.

Selon un mode de réalisation, ledit au moins un élément à braser est compris dans une fenêtre découpée dans ladite partie principale.

Ainsi, la technique décrite est particulièrement adaptée à la technique de brasage par thermode dans sa mise en oeuvre dite « à fenêtre ».

Dans un mode de réalisation de l'invention, ledit au moins un élément à braser s'étend à partir d'un côté extérieur de ladite partie principale.

Ainsi, la technique décrite est également applicable à la technique de brasage par thermode dans sa mise en oeuvre dite « à pistes exposées ».

Selon une caractéristique particulière, ladite partie principale comprend au moins deux zones de connexion comprenant chacune au moins un élément à braser, et, pour chacune desdites au moins deux zones de connexion, au moins une partie rabattable.

Dans un mode de réalisation, ladite au moins une partie rabattable comprend un treillis de sécurité comprenant au moins une première piste conductrice et recouvrant au moins ledit au moins un élément à braser quand ladite au moins une partie rabattable est dans l'état rabattu.

Ainsi, la partie rabattable faisant partie intégrante du FPC, elle bénéficie des dispositifs que ce circuit souple intègre dans le but de détecter une tentative d'accès aux signaux qui transitent par les pistes comprises entre les deux couches de matière plastique souple qui le composent. Notamment, un treillis disposé sur la partie rabattable peut être connecté à d'autres dispositifs de détection d'intrusion présents sur la partie principale, sans avoir à dupliquer les systèmes de détection correspondants dans le système électronique complet dans lequel le FPC est embarqué. De la sorte, une coupure des pistes conductrices du treillis occasionnée par une tentative de perçage de la partie rabattable dans le but d'accéder aux signaux transitant par les points de brasage est aisément détectée par les systèmes de détection initialement prévus dans le système électronique complet pour la détection des intrusion dans la partie principale, et cela sans surcoût au niveau du système électronique complet.

Selon un mode de réalisation, le circuit imprimé flexible comprend des moyens de détection d'un soulèvement de ladite au moins une partie rabattable, quand ladite au moins une partie rabattable est dans l'état rabattu.

Ainsi, les tentatives d'accès aux points de brasage par soulèvement de la partie rabattable sont détectées.

Dans un mode de réalisation, lesdits moyens de détection d'un soulèvement comprennent au moins une paire de premier et deuxième contacts électriques, ledit premier contact électrique étant positionné sur la partie principale et étant configuré pour venir en contact avec ledit deuxième contact électrique, positionné sur ladite au moins une partie rabattable, quand ladite au moins une partie rabattable est dans l'état rabattu.

Ainsi, le circuit électrique établi via les premier et deuxième contacts électriques s'ouvre en cas de soulèvement de la partie rabattable afin d'accéder aux points de brasure, permettant par là-même la détection de la tentative d'intrusion.

Dans un mode de réalisation, lesdits moyens de détection d'un soulèvement comprennent au moins une portion d'une deuxième piste conductrice localisée dans ladite au moins une partie rabattable et réalisée avec une encre conductrice.

Ce mode de réalisation peut être avantageusement combiné avec un collage de la partie rabattable sur la partie principale dans l'état état rabattu. En effet, une telle encre conductrice (par exemple une encre carbone, argent ou cuivre) se trouve être facilement arrachée en cas de tentative de décollement de la partie rabattable, permettant par là-même de détecter la tentative d'intrusion via la présence du circuit électrique ouvert qui en résulte.

Selon un mode de réalisation, ladite au moins une portion de la deuxième piste conductrice est comprise dans ledit treillis de sécurité.

Ainsi, le treillis permet de mettre en oeuvre à la fois la fonction de détection du perçage et celle de détection du soulèvement de la partie rabattable dans l'état rabattu.

Dans un autre mode de réalisation de l'invention, il est proposé un procédé de connexion sécurisée d'un circuit imprimé flexible tel que décrit précédemment, à un autre circuit. Un tel procédé de connexion sécurisée comprend :
- une étape de brasage dudit au moins un élément à braser sur ledit autre circuit, ladite au moins une partie rabattable étant dans ledit état non rabattu ; puis
- une étape de rabattement de ladite au moins une partie rabattable, pour amener ladite au moins une partie rabattable dans ledit état rabattu.

Un tel procédé permet donc la connexion sécurisée d'un FPC selon l'invention (selon l'un quelconque de ses différents modes de réalisation) à un autre circuit. Ainsi, les caractéristiques et avantages de ce procédé sont les mêmes que ceux du FPC décrit précédemment. En particulier, la mise en oeuvre du procédé revendiqué permet de rendre inaccessibles les points de brasure obtenus, interdisant ainsi l'espionnage des signaux qui y transitent. Par ailleurs, la solution proposée n'implique qu'une portion de FPC supplémentaire (i.e. la partie rabattable) par rapport à un FPC de l'état de la technique. Le coût de la solution proposé reste ainsi minimal et le FCP obtenu après rabattement reste tout à fait plat.

Dans un mode de réalisation, ladite étape de rabattement comprend une sous-étape d'application d'un matériau adhésif dans au moins une partie d'une zone de recouvrement partiel de la partie principale par ladite au moins une partie rabattable, quand ladite au moins une partie rabattable est dans l'état rabattu.

Ainsi, une piste en encre conductrice (par exemple une encre carbone, argent ou cuivre) présente sur la partie rabattable se trouve être facilement arrachée en cas de tentative de décollement de la partie rabattable, permettant par là-même de détecter la tentative d'intrusion via la présence du circuit électrique ouvert qui en résulte.

Dans un mode de réalisation, ladite étape de rabattement comprend une sous-étape d'assemblage indirect de la partie principale avec ladite au moins une partie rabattable, par utilisation d'au moins une pièce intermédiaire.

Ainsi, le FPC obtenu par mise en oeuvre du procédé revendiqué est apte à maintenir un contact électrique entre des contacts disposés sur la partie rabattable et sur la partie principale, permettant par là-même de détecter une tentative de soulèvement de la partie rabattable afin d'accéder aux points de brasure.

Dans un mode de réalisation, ladite étape de rabattement est suivie d'une étape de détection d'un soulèvement de ladite au moins une partie rabattable, quand ladite au moins une partie rabattable est dans l'état rabattu.

Ainsi, toute tentative d'accès aux signaux qui transitent par les points de brasure obtenus est détectée.

### 4 LISTE DES FIGURES

D'autres caractéristiques et avantages de l'invention apparaîtront à la lecture de la description suivante, donnée à titre d'exemple indicatif et non limitatif, et des dessins annexés, dans lesquels :
- les figures 1a et 2a illustrent respectivement une première face et une deuxième face d'un FPC selon un mode de réalisation de l'invention ;
- la figure 1b est un zoom sur la zone de brasage présente sur la première face de la figure la ;
- la figure 2b est un zoom sur la zone de chauffage présente sur la deuxième face de la figure 2a ;
- la figure 3 est un organigramme d'un procédé de sécurisation d'un FPC selon un mode de réalisation de l'invention ;
- les figures 4a, 4b et 4c illustrent les états successifs du FPC lors de la mise en oeuvre du procédé de la figure 3 ;
- la figure 5 illustre le résultat du brasage et de la sécurisation du FPC des figures 1a et 2a à un circuit imprimé rigide ;
- les figures 6a, 6b et 6c illustrent différents modes de réalisation de moyens de détection d'une tentative d'accès aux signaux échangés entre le FPC et un circuit auquel il est brasé ;
- la figure 7 illustre la deuxième face d'un FPC selon un autre mode de réalisation de l'invention

### 5 DESCRIPTION DETAILLEE DE L'INVENTION

Sur toutes les figures du présent document, les éléments et étapes identiques sont désignés par une même référence.

Le principe général de la technique décrite consiste en un FPC comprenant des éléments à braser, autrement appelés « contacts à braser » (ou « soldering pad » en anglais), possédant chacun une face à braser accessible depuis une première face du circuit imprimé flexible, et une face à chauffer, accessible depuis une deuxième face du circuit imprimé flexible. Le FPC comprend en outre une partie principale, comprenant les éléments à braser, et une partie rabattable, s'étendant à partir de la partie principale et configurée pour passer d'un état non rabattu, dans lequel elle ne recouvre pas les faces à chauffer des éléments à braser, à un état rabattu, dans lequel elle recouvre les faces à chauffer des éléments à braser. De la sorte, les contacts à braser, ainsi que les signaux électriques y transitant, ne sont plus accessibles après brasage malgré l'utilisation d'une technique de brasage à thermode du type « à fenêtre » ou « à pistes exposées ».

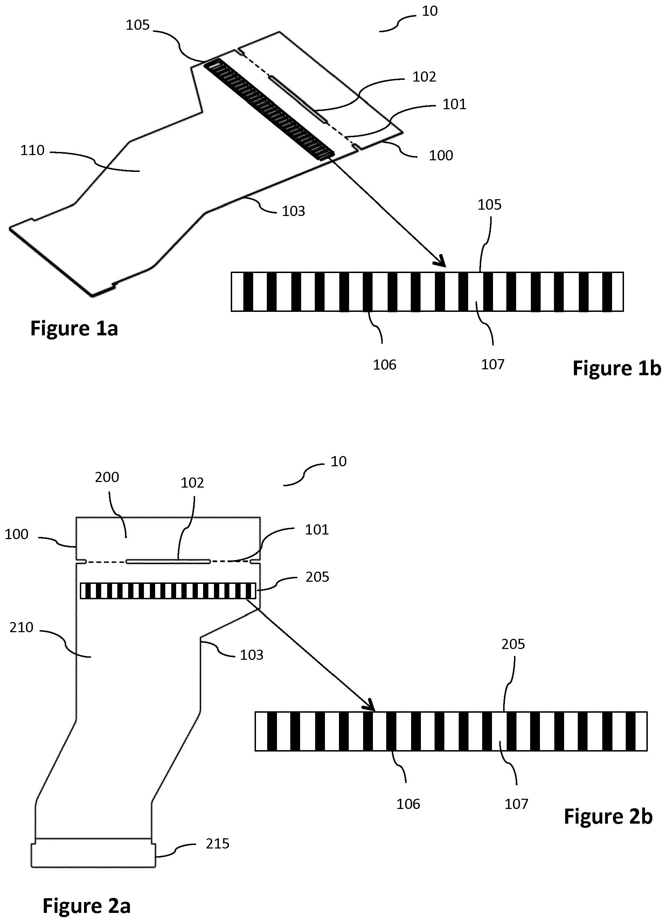

On décrit maintenant, en relation avec les **figures 1a et 2a****,** une première 110 et une deuxième 210 face d'un FPC 10 selon un mode de réalisation de l'invention et, en relation avec les **figures 1b et 2b****,** un zoom sur les zones de brasage 105 et de chauffage 205 correspondantes.

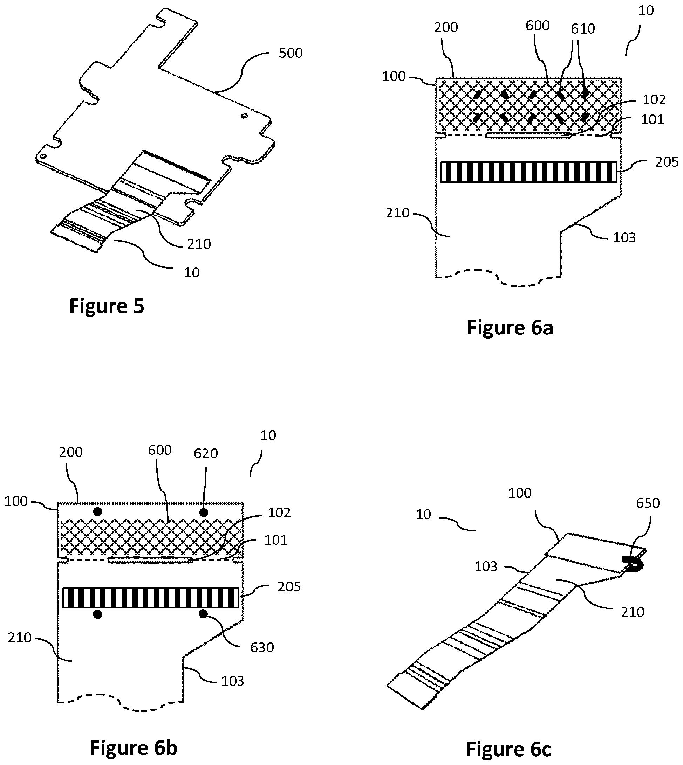

Dans ce mode de réalisation, le FPC 10 (aussi appelé « limande »), présente une première face 110 comprenant la zone de brasage 105 dans laquelle se trouvent des éléments à braser 106, i.e. des portions de pistes du FPC 10 devant être brasées, par exemple, à un autre circuit imprimé (par exemple un circuit imprimé rigide référencé 500 sur la figure 5 décrite ci-dessous).

La zone de brasage 105 est une zone nue, i.e. une zone sur laquelle la couche de matière plastique souple (e.g. du type polyimide) présente sur la première face 110 du FPC 10 a été retirée de manière à laisser apparent l'ensemble des éléments à braser 106.

Par ailleurs, la zone de brasage 105 présente des orifices 107 traversant le FPC 10 et débouchant sur la deuxième face 210 du FPC 10 dans la zone de chauffage 205 de celle-ci. La zone de brasage 105 et la zone de chauffage 205 définissent ainsi une fenêtre comprenant les orifices 107 et les éléments à braser 106. La zone de chauffage 205 et également une zone nue, i.e. une zone sur laquelle la couche de matière plastique souple (e.g. du type polyimide) présente sur la deuxième face 210 du FPC 10 a été retirée de manière à laisser apparent l'ensemble des éléments à braser 106. La zone de chauffage est destinée à recevoir la thermode (ou « hot bar ») dans le but de braser les éléments à braser 106 sur l'autre circuit imprimé (500) du côté de la zone de brasage 105, mettant ainsi en oeuvre une technique de brasage à thermode du type « à fenêtre ».

Le FPC 10 présente par ailleurs une partie rabattable 100 configurée pour (i.e. apte à et destinée à) être rabattue sur la zone de chauffage 205 de manière à empêcher l'accès aux signaux électriques transitant par les éléments à braser 106 une fois brasés. Plus particulièrement, la partie rabattable 100 présente une face de mise en contact 200 correspondant à une première partie de la deuxième face 210 du FPC 10 et qui est destinée à venir en contact avec une deuxième partie de la deuxième face 210 du FPC 10, au niveau de la zone de chauffage 205.

Par ailleurs, la partie rabattable 100 est délimitée du reste du FPC 10 (aussi appelée partie principale 103 du FPC 10) par une rainure de pliage 101 comprenant ici des fentes 102 facilitant le pliage. La rainure de pliage 101 permet de rabattre la partie rabattable 100 sur la zone de chauffage 205 de manière à ce que la partie rabattable 100 soit parfaitement plaquée contre la partie principale 103 du FPC 10. Le FPC 10 ainsi obtenu après rabattement reste particulièrement plat, minimisant ainsi l'encombrement du FPC 10.

Selon ce mode de réalisation, le FPC 10 comprend une zone de brasage 105 et une zone de chauffage 205 superposées, lui permettant d'être assemblé (brasé) selon la technique décrite à un autre circuit imprimé (500). Le FPC 10 comprend également à une autre extrémité un connecteur carte à carte 215 afin d'être connecté de manière réversible à encore un autre circuit imprimé. Dans d'autres modes de réalisation, le FPC est connecté à différents circuits imprimés en utilisant la technique décrite et présente alors différentes zones de brasage et différentes zones de chauffage correspondantes.

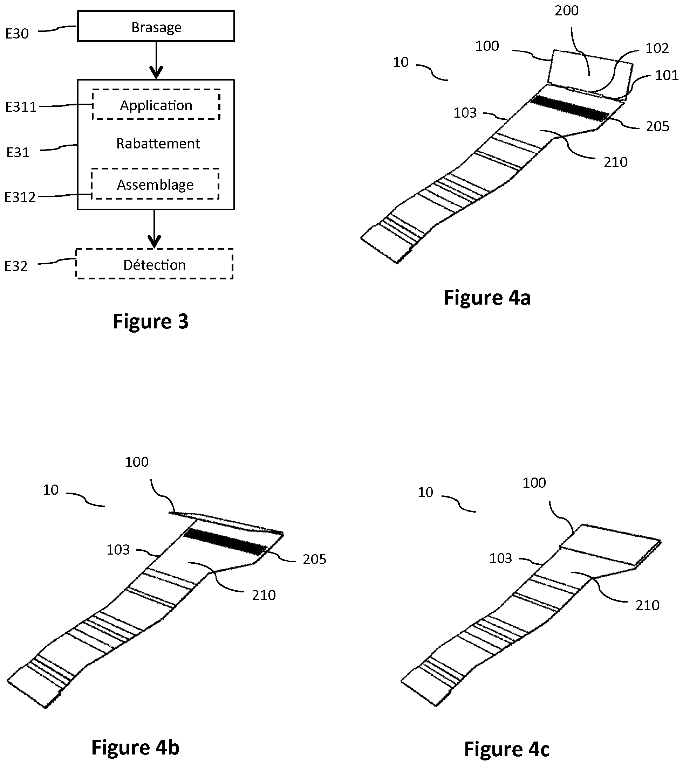

On décrit maintenant, en relation avec les **figures 3, 4a, 4b et 4c** les étapes d'un procédé de sécurisation d'un FPC 10 selon un mode de réalisation de l'invention.

Lors d'une étape de brasage E30, les éléments à braser 106 du FPC 10 sont brasés à des conducteurs électriques (par exemple à des pistes) d'un circuit imprimé rigide (500).

Plus particulièrement, des points de pâtes à braser sont tout d'abord disposés sur les pistes en question du circuit imprimé rigide.

Puis, les éléments à braser 106 du FPC 10 sont disposés contre les points de pâtes à braser, la première face 110 du FPC 10 étant donc orientée vers le circuit imprimé rigide (500), et la zone de brasage 105 étant plaquée contre les pistes du circuit imprimé rigide sur lesquelles sont disposés les points de pâtes à braser.

Une thermode (ou « hot bar » en anglais) est ensuite apposée sur la zone de chauffage 205 de manière à être en contact avec les éléments à braser 106. Ainsi, la pâte à braser est chauffée jusqu'à un point de fusion par conduction de la chaleur fournie par la thermode via les éléments à braser 106.

Une fois les éléments à braser 106 brasés aux pistes du circuit imprimé rigide, le FPC 10 est sécurisé lors d'une étape de rabattement E31.

Plus particulièrement, la partie rabattable 100 est rabattue sur la zone de chauffage 205 par pliage au niveau de la rainure de pliage 101 (comprenant ici trois fentes). Les figures 4a, 4b et 4c illustrent l'état du FPC avant, pendant et après rabattement respectivement. Ainsi, la face de mise en contact 200 se retrouve plaquée contre la deuxième face 210 du FPC 10. Il en résulte que les éléments à braser 106 ne sont plus accessibles depuis la deuxième face 210 de la partie principale 103 du FPC 10, interdisant par là-même l'accès aux signaux électriques qui y transitent. Par ailleurs, le FPC 10 ainsi obtenu après rabattement reste particulièrement plat, minimisant par là-même l'encombrement du FPC 10 une fois sécurisé.

Dans une implémentation, l'étape de rabattement E31 comprend une sous-étape E311 d'application d'un matériau adhésif sur au moins une partie d'une zone de recouvrement partiel de la partie principale 103 par la partie rabattable 100 avant mise en contact de ces deux parties. Ainsi, la face de mise en contact 200 de la partie rabattable 100 se trouve être collée à la deuxième face 210 du FPC 10.

Dans une variante, combinable ou non avec l'implémentation décrite ci-dessus mettant en oeuvre la sous-étape E311 d'application d'un matériau adhésif, l'étape de rabattement E31 comprend une sous-étape E312 d'assemblage indirect de la partie principale 103 avec la partie rabattable 100. Ainsi, la partie rabattable 100 se trouve être maintenue par pression sur la deuxième face 210 de la partie principale du FPC 10 par utilisation d'au moins une pièce intermédiaire 650 comme décrit ci-dessous en relation avec la figure 6c.

Dans une autre variante, l'étape de rabattement E31 est suivie d'une étape de détection E32 d'un soulèvement de la partie rabattable 100 quand cette dernière est rabattue sur la zone de chauffage 205, la face de mise en contact 200 se retrouvant plaquée contre la deuxième face 210 du FPC 10. Ainsi, toute tentative d'accès aux signaux qui transitent par les points de brasure obtenus est détectée, par exemple en mettant en oeuvre les moyens décrits ci-dessous en relation avec les figures 6a, 6b et 6c.

On décrit maintenant, en relation avec la **figure 5**, un FPC 10 selon un mode de réalisation de l'invention après brasage à un circuit imprimé électronique rigide 500, ou PCB (pour « Printed Circuit Board » en anglais), et après rabattement de la partie rabattable 100.

Il apparaît ainsi que la zone de chauffage 205, et donc également les éléments à braser 106, ne sont plus accessibles depuis la deuxième face 210 du FPC 10 lorsque la partie rabattable 100 a été rabattue sur la zone de chauffage 205 lors d'une mise en oeuvre de l'étape E31 du procédé décrit ci-dessus en relation avec la figure 3.

On décrit maintenant, en relation avec les **figures 6a, 6b et 6c**, différents modes de réalisation de moyens de détection d'une tentative d'accès aux signaux échangés entre le FPC et un circuit auquel il est brasé.

Dans un premier mode de réalisation illustré sur la figure 6a, la partie rabattable 100 comprend un treillis conducteur 600 destiné à détecter une tentative d'accès aux signaux transitant par les éléments à braser 106, par exemple par perforation de la partie rabattable 100 une fois rabattue sur la zone de chauffage 205. En effet, le circuit-ouvert (ou le court-circuit) dans le treillis résultant de la tentative de perforation peut être aisément détecté (e.g. par des moyens de détection de variation d'impédance bien connus de l'homme du métier).

Dans une variante, ce treillis est relié à un treillis de sécurité présent sur la partie principale 103. Ainsi, les moyens de détection initialement prévus pour la mise en oeuvre de la détection d'un perçage du treillis de sécurité présent sur la partie principale 103 (e.g. par un processeur ou un circuit dédié auquel sont reliés les treillis en question via un bus) sont également aptes à détecter un perçage du treillis conducteur 600 présent la partie rabattable 100, et cela sans adaptation particulière nécessaire. La détection d'une tentative de perçage de la partie rabattable dans le but d'accéder aux signaux transitant par les points de brasage est ainsi aisément détectée, sans surcoût au niveau du système électronique complet dans lequel le FPC est embarqué.

Dans un second mode de réalisation illustré également sur la figure 6a, la face de mise en contact 200 comprend des sections de pistes en encre conductrice 610 (par exemple une encre carbone, argent ou cuivre). Par ailleurs la face de mise en contact est collée à la deuxième face 210 du FPC 10 après brasage des éléments à braser 106, par exemple suite à une mise en oeuvre de la sous-étape E311 d'application d'un matériau adhésif décrite ci-dessus en relation avec la figure 3. Ainsi, les pistes en encre conductrice 610 se trouvent être arrachées en cas de tentative de décollement de la partie rabattable 100. De la sorte, une tentative d'intrusion par décollement de la partie rabattable 100 est détectée via la présence du circuit électrique ouvert qui résulte de la rupture des pistes en encre conductrice 610 lors d'une mise en oeuvre de l'étape de détection E32 également décrite ci-dessus en relation avec la figure 3.

Le second mode de réalisation peut être combiné ou non au premier mode de réalisation. Dans le cas où les premier et second modes de réalisation sont combinés, les sections de pistes en encre conductrice 610 font parties du treillis conducteur 600.

Dans un troisième mode de réalisation illustré sur les figures 6b et 6c (et pouvant être combiné avec le premier mode de réalisation), la face de mise en contact 200 comprend des premiers dispositifs conducteurs 620 destinés à coopérer avec des deuxièmes dispositifs conducteurs 630 présents sur la deuxième face 210 de la partie principale 103 du FCP, ici placés à proximité de la zone de chauffage 205. Ainsi, lorsque la partie rabattable 100 est rabattue, les premiers 620 et deuxième 630 dispositifs conducteurs sont mis en contact électrique. Pour ce faire, la partie rabattable est maintenue par pression sur la deuxième face 210 du FPC 10, par exemple à l'aide un dispositif de maintien par pincement 650, mettant ainsi en oeuvre une sous-étape E312 d'assemblage indirect de la partie principale 103 avec la partie rabattable 100 comme décrit ci-dessus en relation avec la figure 3. Ainsi, en cas de tentative de soulèvement de la partie rabattable 100 une fois mise en place sur la zone de chauffage 205, le contact électrique entre les premiers 620 et deuxième 630 dispositifs conducteurs se retrouve ouvert, permettant par là-même de détecter la tentative d'intrusion lors d'une mise en oeuvre de l'étape de détection E32 décrite ci-dessus en relation avec la figure 3.

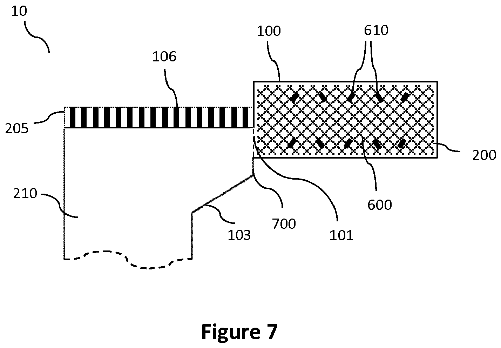

On décrit maintenant, en relation avec la **figure 7**, un FPC 10 selon un autre mode de réalisation de l'invention avant brasage à un autre circuit imprimé électronique et avant rabattement de la partie rabattable 100.
En effet, les modes de réalisation illustrés sur les figures 1a, 1b, 2a, 2b, 4a, 4b, 6a et 6b correspondent à des configurations du type « à fenêtre », i.e. où la zone de chauffage est cernées par de la matière plastique souple. Cependant, la technique décrite, selon l'un quelconque de ses différents modes de réalisation, s'applique de la même façon à une configuration du type « à pistes exposées » où les éléments à braser 106 sont apparents à une extrémité du FPC 10 s'étendant à partir d'un côté extérieur 700 de la partie principale 103 comme illustré sur la figure 7.

## Revendications

1. Circuit imprimé flexible (10) comprenant au moins un élément à braser (106) possédant une face à braser, accessible depuis une première face (110) du circuit imprimé flexible, et une face à chauffer, accessible depuis une deuxième face (210) du circuit imprimé flexible, **caractérisé en ce qu'**il comprend une partie principale (103), comprenant ledit au moins un élément à braser, et au moins une partie rabattable (100), s'étendant à partir de ladite partie principale et configurée pour passer :
- d'un état non rabattu, dans lequel ladite au moins une partie rabattable ne recouvre pas la face à chauffer dudit au moins un élément à braser ;
- à un état rabattu, dans lequel ladite au moins une partie rabattable recouvre la face à chauffer dudit au moins un élément à braser.

2. Circuit imprimé flexible selon la revendication 1, **caractérisé en ce que** ledit au moins un élément à braser est compris dans une fenêtre (105, 205) découpée dans ladite partie principale.

3. Circuit imprimé flexible selon la revendication 1, **caractérisé en ce que** ledit au moins un élément à braser s'étend à partir d'un côté extérieur (700) de ladite partie principale.

4. Circuit imprimé flexible selon l'une quelconque des revendications 1 à 3, **caractérisé en ce que** ladite au moins une partie rabattable comprend un treillis (600) de sécurité comprenant au moins une première piste conductrice et recouvrant au moins ledit au moins un élément à braser quand ladite au moins une partie rabattable est dans l'état rabattu.

5. Circuit imprimé flexible selon l'une quelconque des revendications 1 à 4, **caractérisé en ce qu'**il comprend des moyens (610, 620, 630) de détection d'un soulèvement de ladite au moins une partie rabattable, quand ladite au moins une partie rabattable est dans l'état rabattu.

6. Circuit imprimé flexible selon la revendication 5, **caractérisé en ce que** lesdits moyens de détection d'un soulèvement comprennent au moins une paire de premier et deuxième contacts électriques (620, 630), ledit premier contact électrique étant positionné sur la partie principale et étant configuré pour venir en contact avec ledit deuxième contact électrique, positionné sur ladite au moins une partie rabattable, quand ladite au moins une partie rabattable est dans l'état rabattu.

7. Circuit imprimé flexible selon la revendication 5, **caractérisé en ce que** lesdits moyens de détection d'un soulèvement comprennent au moins une portion d'une deuxième piste conductrice (610) localisée dans ladite au moins une partie rabattable et réalisée avec une encre conductrice.

8. Circuit imprimé flexible selon la revendication 7, **caractérisé en ce que** ladite au moins une portion de la deuxième piste conductrice est comprise dans ledit treillis de sécurité.

9. Procédé de connexion sécurisée d'un circuit imprimé flexible, selon l'une quelconque des revendications 1 à 8, à un autre circuit (500), **caractérisé en ce qu'**il comprend :
- une étape de brasage (E30) dudit au moins un élément à braser sur ledit autre circuit, ladite au moins une partie rabattable étant dans ledit état non rabattu ; puis
- une étape de rabattement (E31) de ladite au moins une partie rabattable, pour amener ladite au moins une partie rabattable dans ledit état rabattu.

10. Procédé selon la revendication 9, **caractérisé en ce que** ladite étape de rabattement comprend une sous-étape (E311) d'application d'un matériau adhésif dans au moins une partie d'une zone de recouvrement partiel de la partie principale par ladite au moins une partie rabattable, quand ladite au moins une partie rabattable est dans l'état rabattu.

11. Procédé selon la revendication 9 ou 10, **caractérisé en ce que** ladite étape de rabattement comprend une sous-étape d'assemblage (E312) indirect de la partie principale avec ladite au moins une partie rabattable, par utilisation d'au moins une pièce intermédiaire (650).

12. Procédé selon l'une quelconque des revendications 9 à 11, **caractérisé en ce que** ladite étape de rabattement est suivie d'une étape de détection (E32) d'un soulèvement de ladite au moins une partie rabattable, quand ladite au moins une partie rabattable est dans l'état rabattu.

## Patentansprüche

1. Flexible Leiterplatte (10), umfassend mindestens ein Lötelement (106), das eine Lötfläche, die von einer ersten Fläche (110) der flexiblen Leiterplatte aus zugänglich ist, und eine zu beheizende Fläche aufweist, die von einer zweiten Fläche (210) der flexiblen Leiterplatte aus zugänglich ist, **dadurch gekennzeichnet, dass** sie einen Hauptteil (103), der mindestens ein Lötelement aufweist, und mindestens einen umklappbaren Teil (100) aufweist, der sich ausgehend von dem Hauptteil erstreckt und konfiguriert ist, um:
- von einem nicht umgeklappten Zustand, in dem der mindestens eine umklappbare Teil die zu beheizende Fläche des mindestens einen Lötelements nicht bedeckt,
- in einen umgeklappten Zustand überzugehen, in dem der mindestens eine umklappbare Teil die zu beheizende Fläche des mindestens einen Lötelements bedeckt.

2. Flexible Leiterplatte nach Anspruch 1, **dadurch gekennzeichnet, dass** das mindestens eine Lötelement in einem Fenster (105, 205) enthalten ist, das in dem Hauptteil ausgeschnitten ist.

3. Flexible Leiterplatte nach Anspruch 1, **dadurch gekennzeichnet, dass** sich das mindestens eine Lötelement ausgehend von einer Außenseite (700) des Hauptteil erstreckt.

4. Flexible Leiterplatte nach einem der Ansprüche 1 bis 3, **dadurch gekennzeichnet, dass** der mindestens eine umklappbare Teil ein Sicherheitsgeflecht (600) aufweist, das mindestens eine erste Leiterbahn aufweist und mindestens das mindestens eine Lötelement bedeckt, wenn sich der mindestens eine umklappbare Teil in dem umgeklappten Zustand befindet.

5. Flexible Leiterplatte nach einem der Ansprüche 1 bis 4, **dadurch gekennzeichnet, dass** sie Mittel (610, 620, 630) zum Erfassen eines Anhebens des mindestens einen umklappbaren Teils aufweist, wenn sich der mindestens eine umklappbare Teil in dem umgeklappten Zustand befindet.

6. Flexible Leiterplatte nach Anspruch 5, **dadurch gekennzeichnet, dass** die Mittel zum Erfassen eines Anhebens mindestens ein Paar eines ersten und zweiten elektrischen Kontakts (620, 630) aufweist, wobei der erste elektrische Kontakt auf dem Hauptteil angeordnet ist und konfiguriert ist, um mit dem zweiten elektrischen Kontakt in Kontakt zu kommen, der auf mindestens einem umklappbaren Teil angeordnet ist, wenn sich der mindestens eine umklappbare Teil in dem umgeklappten Zustand befindet.

7. Flexible Leiterplatte nach Anspruch 5, **dadurch gekennzeichnet, dass** die Mittel zum Erfassen eines Anhebens mindestens einen Abschnitt einer zweiten Leiterbahn (610) aufweisen, der in dem mindestens einen umklappbaren Teil angeordnet ist und mit einer elektrisch leitenden Tinte erstellt ist.

8. Flexible Leiterplatte nach Anspruch 7, **dadurch gekennzeichnet, dass** mindestens ein Abschnitt der zweiten Leiterbahn in dem Sicherheitsgeflecht enthalten ist.

9. Gesichertes Anschlussverfahren einer flexiblen Leiterplatte nach einem der Ansprüche 1 bis 8 an eine andere Schaltung (500), **dadurch gekennzeichnet, dass** es aufweist:
- einen Lötschritt (E30) des mindestens einen Lötelements auf die andere Schaltung, wobei sich mindestens ein umklappbarer Teil in dem nicht umgeklappten Zustand befindet, und dann
- einen Umklappschritt (E31) des mindestens einen umklappbaren Teils, um den mindestens einen umklappbaren Teil in den umgeklappten Zustand zu bringen.

10. Verfahren nach Anspruch 9, **dadurch gekennzeichnet, dass** der Umklappschritt einen Unterschritt (E311) des Auftragens eines Haftmaterials in mindestens einem Teil eines Bereichs der teilweisen Abdeckung des Hauptteils durch den mindestens einen umklappbaren Teil aufweist, wenn sich der mindestens eine umklappbare Teil in dem umgeklappten Zustand befindet.

11. Verfahren nach Anspruch 9 oder 10, **dadurch gekennzeichnet, dass** der Umklappschritt einen Unterschritt des indirekten Zusammenfügens (E312) des Hauptteils mit dem mindestens einen umklappbaren Teil aufweist, indem mindestens ein Zwischenstück (650) verwendet wird.

12. Verfahren nach einem der Ansprüche 9 bis 11, **dadurch gekennzeichnet, dass** auf den Umklappschritt ein Schritt zum Erfassen (E32) eines Anhebens des mindestens einen umklappbaren Teils folgt, wenn sich der mindestens eine umklappbare Teil in dem umgeklappten Zustand befindet.

## Claims

1. Flexible printed circuit board (10) comprising at least one soldering element (106) possessing a soldering face, accessible from a first face (110) of the flexible printed circuit board, and a heating face, accessible from a second face (210) of the flexible printed circuit board, **characterized in that** it comprises a main part (103), comprising said at least one soldering element, and at least one foldable part (100), extending from said main part and being configured to pass:
- from a non-folded state, in which said at least one foldable part does not cover the heating face of said at least one soldering element;
- to a folded state in which said at least one foldable part covers the heating face of said at least one soldering element.

2. Flexible printed circuit board according to claim 1, **characterized in that** said at least one soldering element is included in a window (105, 205) cut out in said main part.

3. Flexible printed circuit board according to claim 1, **characterized in that** said at least one soldering element extends from an external side (700) of said main part.

4. Flexible printed circuit board according to any one of the claims 1 to 3, **characterized in that** said at least one foldable part comprises a security mesh (600) comprising at least one first conductive track and covering at least said at least one soldering element when said at least one foldable part is in the folded state.

5. Flexible printed circuit board according to any one of the claims 1 to 4, **characterized in that** it comprises means (610, 620, 630) for detecting a lifting of said at least one foldable part when said at least one foldable part is in the folded state.

6. Flexible printed circuit board according to claim 5, **characterized in that** said means for detecting a lifting comprise at least one pair of first and second electrical contacts (620, 630), said first electrical contact being positioned on the main part and being configured to come into contact with said second electrical contact, positioned on said at least one foldable part, when said at least one foldable part is in the folded state.

7. Flexible printed circuit board according to claim 5, **characterized in that** said means for detecting a lifting comprises at least one portion of a second conductive track (610) located in said at least one foldable part and made with a conductive ink.

8. Flexible printed circuit board according to claim 7, **characterized in that** said at least one portion of the second conductive track is included in said security mesh.

9. Method for the secured connection of a flexible printed circuit board, according to any one of the claims 1 to 8, to another circuit (500), **characterized in that** it comprises:
- a step (E30) for soldering said at least one soldering element to said another circuit, said at least one foldable part being in said non-folded state; then
- a step (E31) for folding said at least one foldable part, to take said at least one foldable part into said folded state.

10. Method according to claim 9, **characterized in that** said step for folding comprises a sub-step (E311) for applying an adhesive material in at least one part of an area of partial overlapping of the main part by said at least one foldable part, when said at least one foldable part is in the folded state.

11. Method according to claim 9 or 10, **characterized in that** said step for folding comprises a sub-step (E312) for the indirect assembling of the main part with said at least one foldable part, by the use of at least one intermediate part (650).

12. Method according to any one of the claims 9 to 11, **characterized in that** said step for folding is followed by a step (E32) for detecting a lifting of said at least one foldable part, when said at least one foldable part is in the folded state.
